# FASCICULE DE BREVET EUROPEEN

(11) **EP 0 392 945 B1**
(45) Date de publication et mention de la délivrance du brevet: **05.01.1994**
(21) Numéro de dépôt: 90420182.9
(22) Date de dépôt: 11.04.1990
(51) Int. Cl.: G01R 33/028

(54) **Micromagnétomètre à détection capacitive**
Mikromagnetometer mit kapazitiver Detektion
Micromagnetometer with capacitive detection

(30) Priorité: 14.04.1989 FR 8905281
(43) Date de publication de la demande: 17.10.1990
(73) Titulaire: SEXTANT Avionique, F-92366 Meudon la Forêt Cedex (FR)
(72) Inventeur: Donzier, Eric, F-74000 Annecy (FR); Thomas, Isabelle, F-26000 Valence (FR); Spirkovitch, Serge, F-75015 Paris (FR); Baillieu, François, F-94440 Marolles en Brie (FR)
(74) Mandataire: de Beaumont, Michel

(56) Documents cités:
- GB-A- 1 279 091
- GB-A- 2 136 581

## Description

La présente invention concerne un micromagnétomètre.

On a développé ces dernières années des micromagnétomètres réalisés par des techniques similaires aux techniques utilisées dans le domaine de la fabrication des circuits intégrés. Ces micromagnétomètres sont généralement constitués à partir d'une plaquette de silicium et d'une aile ou volet en silicium portant elle-meme un bobinage. Quand un courant constant parcourt le bobinage et qu'un champ magnétique est appliqué perpendiculairement à une direction de passage du courant, la déflexion de l'aile ou volet constitue une mesure de l'intensité du champ magnétique. Si le courant électrique est un courant alternatif à la fréquence de résonance du système mécanique, l'amplitude de l'oscillation constitue une indication de la valeur du champ magnétique. Un tel micromagnétomètre est un exemple décrit dans GB-A-2136581.

Les calculs montrent que plus l'aile vibrante est mince, plus la sensibiblité du système est élevée.

Avec les systèmes de l'art antérieur tels qu'ils viennent d'être décrits, dans lesquels la partie vibrante est constituée d'une lamelle de silicium, il n'est pas possible de choisir librement les divers paramètres étant donné qu'il existe une limite inférieure à l'épaisseur que l'on peut conférer à une lamelle de silicium obtenue à partir d'une plaquette de silicium. A titre d'exemple, les plaquettes de silicium sont couramment disponibles dans des épaisseurs de 0,3 à 0,5 mm et l'on arrive à les amincir pour obtenir des ailes ou volets d'une épaisseur de l'ordre de 10 à 15 micromètres. En dessous de ces valeurs, il devient en effet difficile de contrôler avec précision l'épaisseur finale.

En raison de cette contrainte sur les épaisseurs minimales, le concepteur d'un micromagnétomètre n'est pas complètement libre de sélectionner indépendamment divers paramètres tels que les dimensions à choisir pour l'aile vibrante (l'envergure de celle-ci est inévitablement relativement importante et le dispositif occupera une certaine surface de silicium), la fréquence de résonance, etc. En particulier, on est amené à choisir des systèmes qui résonnent à des fréquences de l'ordre de la dizaine de kilohertz, ce qui n'est pas satisfaisant pour permettre de s'affranchir autant que possible des vibrations mécaniques parasites. En outre, les dimensions de l'aile empêchent de s'affranchir totalement des perturbations liées aux accélérations auxquelles pourrait être soumis le système.

Ainsi, un objet de la présente invention est de prévoir un nouveau type de micromagnétomètre.

Un autre objet de la présente invention est de prévoir un tel micromagnétomètre dans lequel la partie vibrante soit aussi fine et légère que possible.

Un autre objet de la présente invention est de prévoir un tel micromagnétomètre dans lequel la partie vibrante occupe une surface aussi faible que possible.

Ces objets de la présente invention sont atteints en prévoyant un micromagnétomètre à détection capacitive comprenant :
- deux couches minces conductrices superposées, séparées par une interface isolante, et formées sur un substrat isolant, au moins la couche supérieure étant gravée pour comprendre un segment de couche rejoint à ses extrémités par deux bandes parallèles orthogonales à ce segment, ledit segment et une partie desdites bandes ainsi que les parties correspondantes de la couche inférieure formant une aile située au-dessus d'un évidement du substrat ;
- une surface conductrice formée dans l'évidement du substrat, au moins en regard dudit segment ;
- des moyens de connexion électrique aux deux bandes de la couche supérieure pour y connecter une source de courant ; et
- des moyens de mesure des variations de capacité entre la couche mince inférieure et la surface conductrice.

Un procédé pour fabriquer un micromagnétomètre selon l'invention comprend les étapes suivantes :
- prévoir un substrat à surface supérieure isolante comprenant au moins une surface conductrice ;
- former, en particulier au-dessus de la surface conductrice, une portion de couche d'un produit sélectivement attaquable par rapport aux surfaces apparentes du substrat ;
- former au-dessus du substrat et de ladite portion de couche d'un produit sélectivement attaquable un sandwich comprenant :
   . une première couche conductrice,
   . une couche isolante,
   . une deuxième couche conductrice ;
- graver ledit sandwich pour en laisser en place une première partie sur le substrat et une deuxième partie sur ladite portion de couche d'un produit sélectivement attaquable, cette deuxième partie étant conformée pour permettre le passage d'un courant dans la couche supérieure conductrice dans une direction principale orthogonale au champ à détecter ; et
- éliminer par attaque sélective ladite portion de couche d'un produit sélectivement attaquable, d'où il résulte que la deuxième partie se trouve en surplomb au-dessus de ladite surface conductrice

Selon un mode de réalisation de la présente invention, les couches conductrices sont des couches d'aluminium et la couche d'isolement est une couche d'alumine ; le substrat est une plaquette de silicium revêtue d'oxyde de silicium ; et la surface conductrice est une portion de couche de silicium polycristallin dopé.

Selon un mode de réalisation de la présente invention, le produit sélectivement attaquable est du silicium polycristallin ou une couche de résine.

Ainsi, un micromagnétomètre selon l'invention présente une structure d'aile vibrante particulièrement légère puisqu'elle comprend seulement deux couches minces de métallisation, par exemple un sandwich constitué de deux couches d'aluminium séparées d'une couche d'alumine. Cette structure vibrante extrêmement légère aura une fréquence de vibration élevée qui pourra, comme cela sera indiqué ci-après, être choisie par le concepteur. Celui-ci pourra notamment sélectionner la dimension de l'aile vibrante, ou le métal constituant les diverses couches conductrices. Si on compare un micromagnétomètre selon la présente invention à un micromagnétomètre à ailes en silicium selon l'art antérieur, on notera que le micromagnétomètre selon la présente invention présentera un coefficient de qualité Q plus important, c'est-à-dire une plus forte sensibilité.

Ces objets, caractéristiques et avantages ainsi que d'autres de la présente invention seront exposés plus en détail dans la description suivante de modes de réalisation particuliers faite en relation avec les figures jointes parmi lesquelles :
la figure 1 est une vue en coupe très schématique d'une structure selon la présente invention ;
la figure 2 est une vue en perspective schématique, correspondant à la figure 1 ;
les figures 3A et 3B sont des vues en coupe transversale et longitudinale d'une structure selon la présente invention ;
les figures 4A, 4B et 4C illustrent très schématiquement un aspect du procédé selon la présente invention ; et
la figure 5 représente à titre d'exemple et partiellement sous forme de blocs le schéma électrique d'ensemble d'un détecteur selon la présente invention.

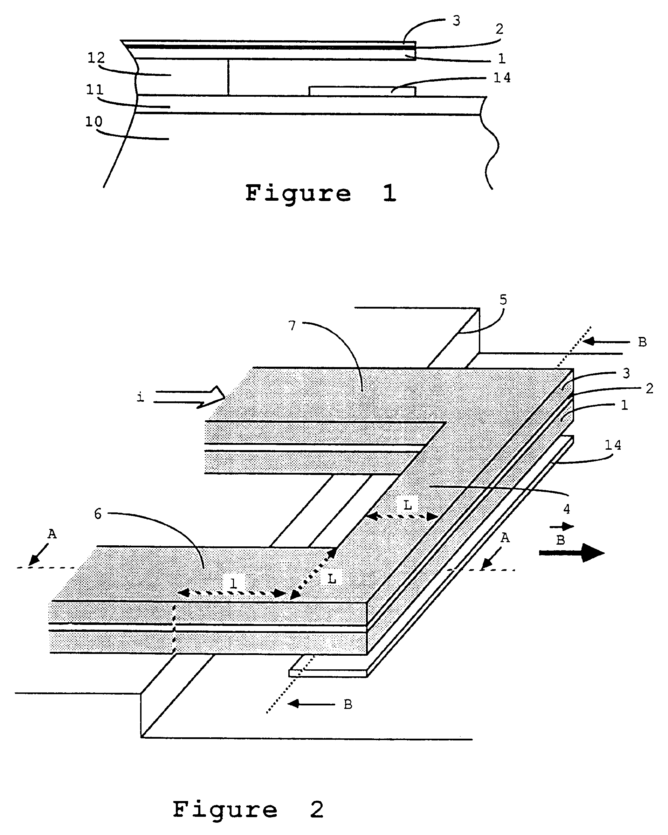

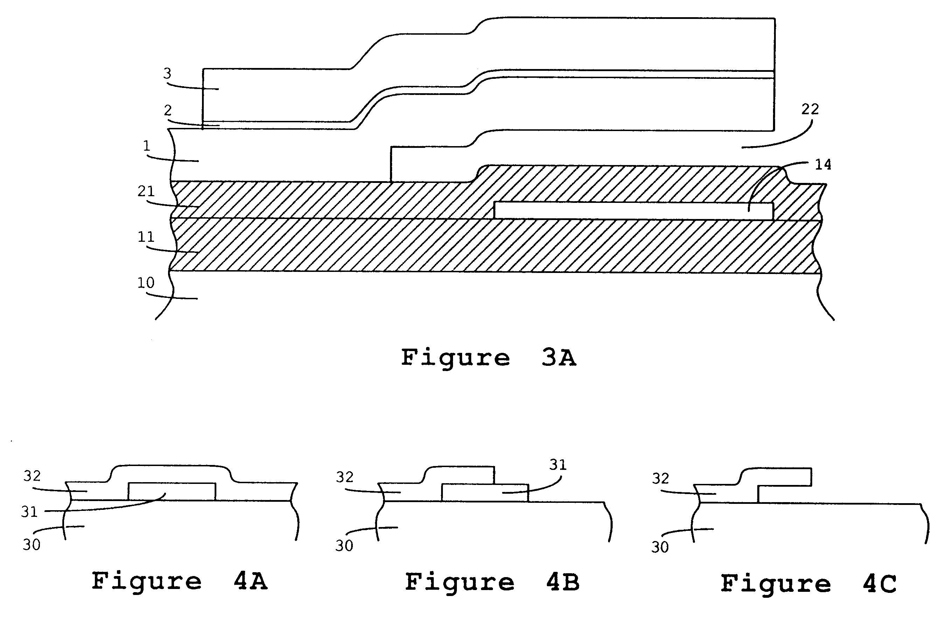

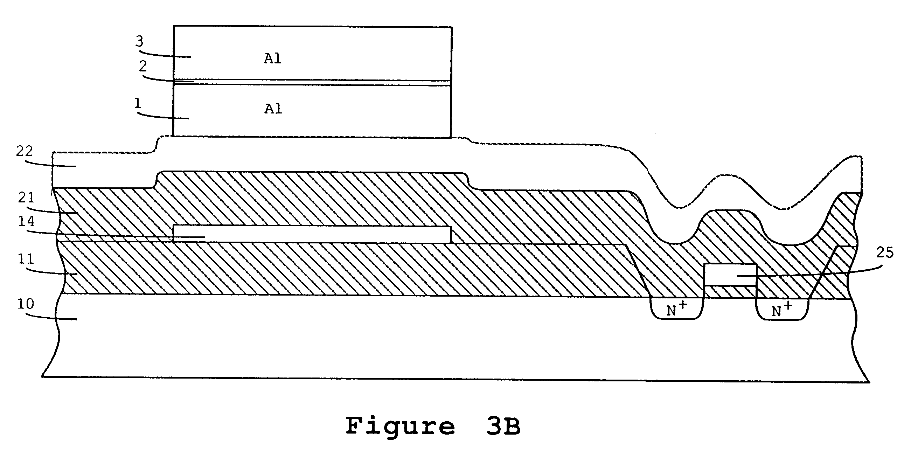

Le principe d'un micromagnétomètre selon la présente invention va d'abord être exposé en relation avec la vue en coupe de la figure 1 et la vue en perspective de la figure 2 qui illustrent de façon très schématique certains aspects de la présente invention.

Selon la présente invention, il est prévu une poutre constituée d'un sandwich comprenant une première couche conductrice 1, une couche isolante 2 et une deuxième couche conductrice 3. Une première partie du sandwich repose sur un substrat et une deuxième partie constituant la poutre est en surplomb par rapport à ce substrat. Comme le représente mieux la figure 2, la deuxième partie comprend, du moins en ce qui concerne la couche supérieure 3, un segment 4 orienté selon une première direction sensiblement parallèle à la limite 5 du substrat au delà de laquelle cette deuxième partie se trouve en surplomb. Ce segment 4 est solidaire de deux bandes 6 et 7 qui lui sont orthogonales et qui se prolongent sur le substrat. En d'autres termes, la bande 6, le segment 4 et la bande 7 constituent une portion d'une spire électrique permettant de faire passer dans le segment 4 un courant électrique de valeur choisie, par exemple un courant alternatif. Ainsi, en fonction de l'intensité d'un champ magnétique B orienté perpendiculairement à la direction principale du segment 4, la poutre constituée par la partie en surplomb se défléchira plus ou moins si le courant est continu ou oscillera plus ou moins si le courant est alternatif (par exemple à la fréquence de résonance mécanique de la poutre).

Dans l'exemple de la figure 1, le substrat est constitué d'une plaquette de silicium 10 revêtue d'une première couche d'oxyde de silicium 11 elle-même revêtue d'une deuxième couche de silicium 12 constituant une marche au-delà de laquelle la deuxième partie du sandwich 1, 2, 3 se trouve en surplomb. Pour détecter les déflexions ou les vibrations du segment 4, une portion de couche conductrice 14 est disposée sensiblement en regard du segment 4 et, de façon classique, on détecte la variation de capacité entre la partie de la couche 1 du segment 4 et la portion couche 14, cette capacité étant caractéristique de la distance et des variations de distance entre ces éléments.

Les figures 3A et 3B représentent, de façon plus précise quoiqu'encore très schématiquement, des vues en coupe selon les plans A-A et B-B de la figure 2 et sont destinées à illustrer à titre d'exemple un mode de fabrication d'un capteur selon la présente invention.

On notera que dans ces figures, comme d'ailleurs dans les autres figures, les épaisseurs et dimensions latérales des diverses couches ne sont pas tracées à l'échelle mais, comme cela est classique dans le domaine des circuits intégrés sont arbitrairement dilatées ou réduites pour améliorer la lisibilité des figures. Pour les dimensions de ces diverses couches, on se réfèrera aux usages de la technique à moins que des valeurs particulières ne soient indiquées dans le texte ci-après.

Pour fabriquer une structure telle que celle illustrée en figures 3A et 3B, on part d'un substrat de silicium 10 sur lequel est formé, par oxydation thermique et/ou par dépôt chimique en phase vapeur une couche d'oxyde de silicium 11. Une couche de silicium polycristallin 14, fortement dopée pour être conductrice, est déposée et gravée pour se trouver en face du segment oscillant à former ultérieurement. L'ensemble de la surface et notamment la partie supérieure de la couche de silicium polycristallin est revêtue d'une couche isolante, par exemple de l'oxyde de silicium 21. Sur cette couche est formée une couche de silicium polycristallin 22 qui est gravée pour se trouver notamment en dessous de la deuxième partie du sandwich ci-dessus mentionée dont on veut qu'elle se trouve en surplomb. Ensuite, sont successivement formées une première couche d'aluminium 1 (par exemple par évaporation sous vide), une couche isolante d'alumine 2 (par exemple par oxydation thermique), et une deuxième couche d'aluminium 3 (à nouveau par évaporation sous vide). Le sandwich constitué par les trois couches 1, 2 et 3 est gravé selon le motif souhaité, par exemple conformément à la représentation de la figure 2. Après cela, la couche 22 de silicium polycristallin est éliminée par une attaque sélective par rapport à l'oxyde de silicium, à l'aluminium et à l'alumine et l'on arrive à la structure illustrée.

Bien entendu, la succession d'étapes décrite précédemment ne constitue qu'un exemple des nombreux procédés possibles de réalisation de la structure selon l'invention. En particulier, on pourra prévoir diverses étapes de planarisation pour que la surface supérieure de la couche 21 soit plane et pour que la surface supérieure de la couche de silicium polycristallin 22 se prolonge au même niveau par une surface d'oxyde de façon que la surface supérieure de la poutre soit plane, comme cela a été représenté en figure 1. On pourra ainsi prévoir sous les couches 1, 2 et 3 un conducteur destiné à compenser le champ à mesurer et faisant partie intégrante du micromagnétomètre.

D'autre part, de nombreuses variantes sont possibles quant aux matériaux utilisés. Alors que le silicium et l'oxyde de silicium sont les matériaux les plus couramment disponibles aujourd'hui, d'autres matériaux analogues pourront être utilisés. En outre, au lieu du silicium polycristallin dopé de la couche 14, tout autre matériau conducteur compatible avec le procédé de fabrication pourra être utilisé. De même, au lieu de deux couches d'aluminium 1 et 3, on pourra utiliser des couches d'autres métaux ou alliages métalliques, tels que Ti ou Ti-Cu, du moment qu'elles aient une tenue suffisante pour permettre leur formation en surplomb et une conduction électrique satisfaisante pour laisser passer le courant i destiné à interagir avec le champ électrique B pour fournir un déplacement en raison de la force de Laplace.

La raison essentielle pour laquelle on préfère actuellement utiliser comme substrat un substrat de silicium apparaît dans la partie droite de la figure 33. En effet, le procédé décrit précédemment est compatible avec la fabrication simultanée de transistors MOS dans la plaquette de silicium 10. Comme le notera l'homme de l'art, la grille 25 d'un tel transistor MOS pourra être formée à la même étape que la plaque conductrice 14.

En outre, bien que cela ne soit pas représenté dans les diverses figures par souci de simplification, il sera clair que les diverses couches conductrices se prolongent vers d'autres couches ou vers des plots pour assurer les connexions nécessaires, une des étapes de fabrication finale consistant à réaliser des contacts avec les plots mentionnés.

Les figures 4A, 4B, 4C illustrent de façon générale la formation d'une poutre en surplomb selon l'invention. Comme le représente la figure 4A, sur un substrat 30 est formée une couche 31 d'un produit sélectivement attaquable, revêtue de couches minces 32 du ou des matériaux dont on veut constituer, la poutre. Ensuite, pendant l'étape illustrée en figure 4B, la poutre est gravée selon la configuration souhaitée et enfin, comme cela est illustré à l'étape de la figure 4C, le produit sélectivement attaquable 32 est éliminé.

A titre de matériau sélectivement attaquable, on a suggéré précédemment l'emploi de silicium polycristallin. Il pourra être plus simple dans certaines applications de prévoir une couche de résine.

Si on désigne par 1 la longueur des bandes 6 et 7 orthogonales au segment 4 (voir figure 2), par L la largeur de ces bandes et la largeur du segment, par L₀ la longueur totale du segment 4, et par e l'épaisseur totale du sandwich comprenant les éléments 1, 2 et 3, on obtient avec une structure du type illustré en figure 2 où e = 2 µm :
- une fréquence de résonance de 160 kHz
   avec L = 30 µm, l = 60 µm, L₀ = 120 µm,
   (une accélération de 1 g correspondant à un champ magnétique de 1,5 nT, alors qu'elle correspondrait à 10³ nT pour un micromagnétomètre comparable à aile vibrante en silicium) ;
- une fréquence de résonance de 1,4 MHz
   avec L = 20 µm, l = 10 µm, L₀ = 40 µm.

C'est un avantage de la présente invention, dû notamment à la faible masse de la poutre, que de pouvoir obtenir des fréquences de résonance aussi élevées qui permettant de s'affranchir des vibrations ou accélérations parasites existant couramment dans les systèmes mécaniques, et de diminuer le bruit inversement proportionnel à la fréquence du système électronique de détection.

En outre, et comme cela est souhaitable pour une bonne détectivité, le procédé de fabrication selon la présente invention permet d'obtenir une distance entre les deux plaques d'électrode 4 et 14 permettant de détecter des vibrations de la poutre selon l'invention de très faibles amplitudes. Si cette distance faible permet d'obtenir une capacité de valeur mesurable même pour de petites dimensions de la poutre selon l'invention, elle présente un inconvénient en ce que l'air inclus entre la poutre et la plaque d'électrode de substrat tend à amortir les vibrations. Pour s'affranchir de cet effet, on montera de préférence une structure selon l'invention dans un capot mis sous vide.

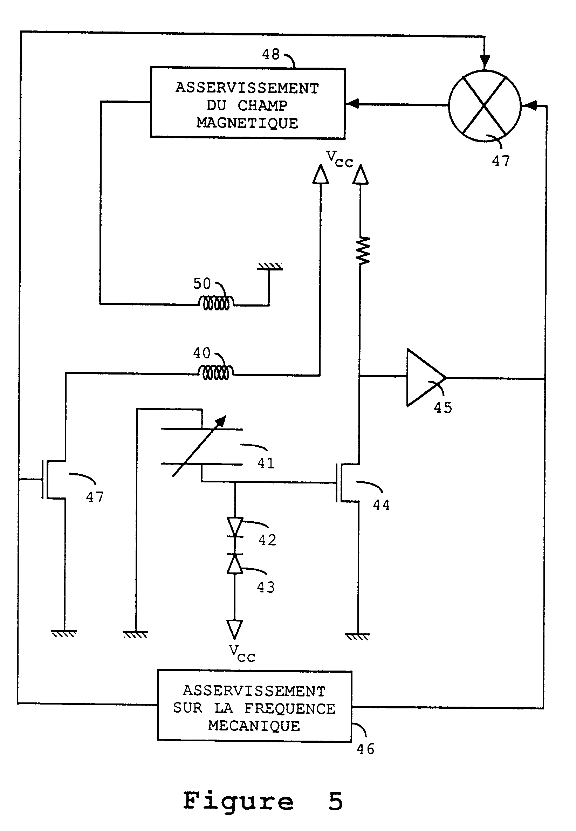

La figure 5 illustre très schématiquement le montage d'un capteur selon la présente invention. Dans le schéma de la figure 5, la spire ou portion en segment de la couche supérieure 3 dans laquelle circule le courant i destiné à interagir avec le champ magnétique appliqué pour faire fléchir ou osciller la structure est désignée par la référence 40. La partie de la couche inférieure 1 du segment 4 constitue une première plaque, reliée à la masse, d'un condensateur 41 dont l'autre plaque correspond à la surface conductrice 14. Cette deuxième plaque est polarisée par une connexion à une source de tension VCC effectuée par l'intermédiaire de deux diodes tête-bêche 42 et 43. Cette deuxième plaque est également reliée à la grille d'un transistor MOS 44, normalement un transistor formé dans la même structure, comme cela est représenté dans la partie droite de la figure 3B. Le montage de polarisation à deux diodes tête-bêche permet de polariser la grille du transistor 44 à la valeur de la tension VCC.

Le signal de sortie amplifié par le transistor MOS 44 est encore amplifié par un amplificateur haute fréquence 45 agissant par l'intermédiaire d'un circuit d'asservissement 46 et d'un transistor MOS 47 connecté en série avec la spire 40 pour asservir le courant dans cette spire 40 à la fréquence de résonance de la poutre (valeur maximale du signal de sortie). En outre, on peut prévoir un conducteur de compensation 50 disposé par exemple sur le substrat précédemment décrit et qui est asservi par un démodulateur synchrone 51 et un circuit d'asservissement 48 pour maintenir à une valeur très faible l'oscillation du capteur selon l'invention et améliorer la linéarité des mesures.

Comme cela a été indiqué au cours de la description qui précède, la présente invention peut être soumise à de nombreuses variantes et perfectionnements qui apparaîtront à l'homme de l'art, notamment en ce qui concerne les matériaux utilisés. Divers procédés de fabrication pourront être choisis parmi les procédés classiques dans le domaine de la fabrication des circuits intégrés.

En outre, on pourra prévoir des variations de forme de la poutre vibrante. Par exemple, la couche conductrice inférieure qui sert de plaque de condensateur n'aura pas nécessairement la même découpe que la couche conductrice supérieure qui sert à laisser passer un courant interagissant avec un champ magnétique. On pourra aussi prévoir de charger la poutre, par un revêtement isolant, par exemple en SiO₂. On pourra également coupler deux structures symétriques de façon à éliminer certains effets parasites.

## Revendications

1. Micromagnétomètre à détection capacitive comprenant :
- deux couches minces conductrices (1, 3) superposées, séparées par une interface isolante (2), et formées sur un substrat isolant, au moins la couche supérieure (3) étant gravée pour comprendre un segment de couche (4) rejoint à ses extrémités par deux bandes parallèles (6, 7) orthogonales à ce segment, ledit segment et une partie desdites bandes ainsi que les parties correspondantes de la couche inférieure formant une aile située au-dessus d'un évidement du substrat ;
- une surface conductrice (14) formée dans l'évidement du substrat, au moins en regard dudit segment ;
- des moyens de connexion électrique aux deux bandes (6,7) de la couche supérieure pour y connecter une source de courant ; et
- des moyens de mesure de variations de capacité entre la couche mince conductrice inférieure (1) et la surface conductrice (14).

2. Micromagnétomètre selon la revendication 1, dans laquelle les couches minces (1,3) ont des épaisseurs de l'ordre d'environ 0,1 à quelques micromètres, en ce que ledit segment (4) a une longueur de l'ordre de quelques dizaines à quelques centaines de micromètres, et en ce que les parties en surplomb desdites bandes ont des longueurs et largeurs de l'ordre de la dizaine de micromètres.

3. Procédé de fabrication d'un élément capteur de micromagnétomètre, comprenant les étapes consistant à :
- prévoir un substrat à surface supérieure isolante (10, 11, 21, 30) comprenant au moins une surface conductrice (14);
- former, en particulier au-dessus de la surface conductrice (14), une portion de couche (22 ; 31) d'un produit sélectivement attaquable par rapport aux surfaces apparentes du substrat ;
- former au-dessus du substrat et de ladite portion de couche d'un produit sélectivement attaquable (22;31) un sandwich comprenant :
. une première couche conductrice (1),
. une couche isolante (2),
. une deuxième couche conductrice (3) ;
- graver ledit sandwich pour en laisser en place une première partie sur le substrat et une deuxième partie sur ladite portion de couche d'un produit sélectivement attaquable (22;31), cette deuxième partie étant conformée pour permettre le passage d'un courant dans la couche supérieure conductrice (3) dans une direction principale orthogonale au champ à détecter ; et
- éliminer par attaque sélective ladite portion de couche d'un produit sélectivement attaquable (22;31), d'où il résulte que la deuxième partie se trouve en surplomb au-dessus de ladite surface conductrice (14).

4. Procédé selon la revendication 3, dans lequel lesdites couches conductrices (1,3) sont des couches d'aluminium et la couche d'isolement (2) est une couche d'alumine.

5. Procédé selon la revendication 3, dans lequel le substrat est une plaquette de silicium (10) revêtue d'oxyde de silicium (11).

6. Procédé selon la revendication 5, dans lequel la surface conductrice (14) est une portion de couche de silicium polycristallin dopé.

7. Procédé selon la revendication 6, dans lequel le produit sélectivement attaquable est du silicium polycristallin, la couche de silicium polycristallin (14) selon la revendication 6 étant elle-même préalablement revêtue d'oxyde de silicium (21).

8. Procédé selon la revendication 3, dans lequel la couche de produit sélectivement attaquable (22, 31) est une couche de résine.

## Patentansprüche

1. Mikromagnetometer mit kapazitiver Detektion, welches umfaßt :
- zwei dünne, übereinander angeordnete Leiterschichten (1, 3), welche durch eine isolierende Zwischenschicht (2) getrennt sind und auf einem isolierenden Substrat ausgebildet sind, wobei zumindest die obere Schicht (3) geätzt ist, so daß sie ein Schichtsegment (4) umfaßt, welches an seinen Enden mit zwei parallelen Streifen (6, 7), welche orthogonal zu diesem Segment sind, zusammenstößt, und wobei das Segment und ein Teil dieser Streifen sowie die entsprechenden Teile der unteren Schicht einen Flügel bilden, welcher sich oberhalb einer Aussparung des Substrats befindet,
- eine leitende Fläche (14), welche in der Aussparung des Substrats zumindest gegenüber dem Segment ausgebildet ist,
- elektrische Verbindungseinrichtungen zu den zwei Streifen (6, 7) der oberen Schicht, um daran eine Stromquelle anzuschließen, und
- eine Meßeinrichtung für die Änderung der Kapazität zwischen der unteren dünnen Leiterschicht (1) und der leitenden Oberfläche (14).

2. Mikromagnetometer nach Anspruch 1, in welchem die dünnen Schichten (1, 3) eine Dicke von der Größenordnung von ungefähr 0.1 µm bis zu einigen µm besitzen, das Segment (4) eine Länge von der Größenordnung von einigen zehn µm bis zu einigen hundert µm besitzt und die überhängenden Abschnitte der Streifen eine Lange und Breite in der Größenordnung von 10 µm besitzen.

3. Verfahren zur Herstellung eines Mikromagnetometer-Sensorelements, welches die Schritte umfaßt:
- Bereitstellen eines Substrats mit einer oberen isolierenden Oberfläche (10, 11, 21, 30), welches wenigstens eine leitende Fläche (14) umfaßt,
- Bilden eines Schichtabschnitts (22; 31) insbesondere oberhalb der leitenden Fläche (14) aus einem Material, das selektiv bezüglich der freiliegenden Oberflächen des Substrats angegriffen werden kann,
- Bilden eines Sandwichs oberhalb des Substrats und des besagten Schichtabschnitts (22; 31) aus einem selektiv angreifbaren Material, welcher umfaßt:
- eine erste Leiterschicht (1),
- eine Isolatorschicht (2),
- eine zweite Leiterschicht (3),
- Ätzen des Sandwichs, so daß davon ein erster Abschnitt auf dem Substrat und ein zweiter Abschnitt auf dem Schichtabschnitt (22; 31) aus einem selektiv angreifbaren Material an ihrem Ort belassen werden, wobei dieser zweite Abschnitt derart geformt ist, daß er das Fließen eines Stroms in der oberen Leiterschicht (3) in einer Hauptrichtung gestattet, die orthogonal zu dem zu detektierenden Feld ist, und
- Beseitigen des Schichtabschnitts (22; 31) aus einem selektiv angreifbaren Material durch selektives Angreifen, woraus resultiert, daß der zweite Abschnitt oberhalb der Leiteroberfläche (14) vorsteht.

4. Verfahren nach Anspruch 3, bei welchem die Leiterschichten (1, 3) Aluminiumschichten sind und die Isolationsschicht (2) eine Aluminiumoxidschicht ist.

5. Verfahren nach Anspruch 3, bei welchem das Substrat ein Silicium-Waver (10) ist, der mit Siliciumoxid (11) überzogen ist.

6. Verfahren nach Anspruch 5, bei welchem die leitende Fläche (14) ein Teil einer Schicht aus dotiertem polykrystallinem Silicium ist.

7. Verfahren nach Anspruch 6, bei welchem das selektiv angreifbare Material aus polykristallinem Silicium besteht, wobei die Schicht aus polykristallinem Silicium (14) nach Anspruch 6 selbst vorher mit Siliciumoxid (21) beschichtet wurde.

8. Verfahren nach Anspruch 3, bei welchem die Schicht aus dem selektiv angreifbaren Material (22; 31) eine Harzschicht ist.

## Claims

1. A capacitive detection micromagnetometer including:
- two thin superposed conductive layers (1, 3), separated by an insulating interface (2) and formed on an insulating substrate, at least the upper layer (3) being etched so as to comprise a layer segment (4) contacted at its ends by two parallel strips (6, 7) placed orthogonally to this segment, said segment and a portion of said strips as well as the portions corresponding to the lower layer forming a wing positioned above a recess of said substrate;
- a conductive surface (14) formed in the substrate recess, at least in register with said segment;
- means for electrically connecting the upper layer to said two strips (6, 7) so as to connect a current source thereto; and
- means for measuring the capacity variations between the thin lower conductive layer (1) and the conductive surface (14).

2. The micromagnetometer of claim 1, wherein the widths of said thin layers (1, 3) are within the range of approximately 0.1 micrometer to a few micrometers, and wherein said segment (4) has a length within a range of approximately a few tens to a few hundred of a micrometer, and wherein the portions that are extending beyond said strips have lengths and widths of approximately 10 µm.

3. A process for manufacturing a micromagnetometer sensor element including the steps of:
- providing a substrate having an insulating upper surface (10, 11, 21, 30) including at least one conductive surface (14);
- forming, more particularly above the conductive surface (14), a layer portion (22; 31) of a product that can be selectively etched with respect to the apparent surfaces of the substrate;
- forming above the substrate and said layer portion of a product that can be selectively etched (22; 31) a sandwich including:
. a first conductive layer (1),
. an insulating layer (2),
. a second conductive layer (3);
- etching said sandwich so as to leave in place a first portion on the substrate and a second portion on said layer portion of a product that can be selectively etched (22; 31), said second portion being formed so as to enable the flow of a current in the upper conductive layer (3) in a main direction, orthogonal to the electrical field to be detected; and
- removing by selective etching said layer portion of a product that can be selectively etched (22; 31), whereby the second portion extends above said conductive layer (14).

4. The process of claim 3, wherein said conductive layers (1, 3) are aluminum layers and the insulating layer (2) is an alumina layer.

5. The process of claim 3, wherein the substrate is a silicon wafer (10) coated with silicon oxide (11).

6. The process of claim 5, wherein the conductive surface (14) is a layer portion made of doped polycrystalline silicon.

7. The process of claim 6, wherein the product that can be selectively etched is made of polycrystalline silicon, the polycrystalline silicon layer (14), according to claim 6, being in turn previously coated with silicon oxide (21).

8. The process of claim 3, wherein the layer of the product that can be selectively etched (22; 31) is a resist layer.
